## Europäisches Patentamt
## European Patent Office
## Office européen des brevets

(19)

(11) Veröffentlichungsnummer: **0 088 815**
**B1**

(12) ## EUROPÄISCHE PATENTSCHRIFT

(45) Veröffentlichungstag der Patentschrift:
**18.12.85**

(21) Anmeldenummer: **82102142.5**

(22) Anmeldetag: **17.03.82**

(51) Int. Cl.⁴: **G 11 C 17/00**, G 11 C 11/34

(54) **Elektrisch löschbare Speichermatrix (EEPROM).**

(43) Veröffentlichungstag der Anmeldung:
**21.09.83 Patentblatt 83/38**

(45) Bekanntmachung des Hinweises auf die Patenterteilung:
**18.12.85 Patentblatt 85/51**

(84) Benannte Vertragsstaaten:
**DE FR GB IT NL**

(56) Entgegenhaltungen:
**DE - A - 3 103 807**
**US - A - 4 266 283**
**US - A - 4 317 110**

**PATENTS ABSTRACTS OF JAPAN, Band 5, Nr.
1 (P-43)(673)**

(73) Patentinhaber: **Deutsche ITT Industries GmbH,
Hans-Bunte-Strasse 19 Postfach 840, D-7800 Freiburg
(DE)**

(84) Benannte Vertragsstaaten: **DE**

(73) Patentinhaber: **ITT INDUSTRIES INC., 320 Park Avenue,
New York, NY 10022 (US)**

(84) Benannte Vertragsstaaten: **FR GB IT NL**

(72) Erfinder: **Giebel, Burkhard, Dipl.-Ing., Asenweg 15,
D-8000 München 83 (DE)**

(74) Vertreter: **Morstadt, Volker, Dipl.-Ing. et al, c/o Deutsche
ITT Industries GmbH Patent/Lizenzabteilung
Postfach 840 Hans-Bunte-Strasse 19,
D-7800 Freiburg/Brsg. (DE)**

## Beschreibung

Aus «1980 IEEE International Solid-State Circuits Conference, Digest of Technical Papers», Seiten 152 und 153 ist eine elektrisch löschbare Speichermatrix (EEPROM) mit in n Zeilen und m Spalten angeordneten Speicherzellen bekannt. Jede der Speicherzellen enthält einen Tunnelinjektor, der in der Lage ist, in beiden Richtungen zu einer elektrisch schwebenden Elektrode Elektronen durch eine ausreichend dünne Oxidschicht tunneln zu lassen. Der Injektor jeder Speicherzelle ist einerseits über die Source-Drain-Strecke eines Speichertransistors mit einer ersten Bitleitung und andererseits über die Source-Drain-Strecke eines Auswahltransistors mit einer zweiten Bitleitung verbunden, während das Steuergate des Speichertransistors an einer Programmierleitung angeschlossen ist. Das Gate des Auswahltransistors liegt an einer Zeilenwahlleitung, über die zeilenweise die n Speicherzellen jeder Zeile angewählt werden können.

Bei einer aus der US-PS Nr. 4266283 bekannten Speichermatrix mit derartigen Speicherzellen sind diese in Speichergruppen zu je b Speicherzellen angeordnet. Die Speichergruppen wiederum sind in w Blöcken zu b Spalten und in n Zeilen organisiert. Die Gates der w · b=m Auswahltransistoren jeder Zeile sind über eine gemeinsame Zeilenwahlleitung mit je einem von n Ausgängen eines Zeilendekoders verbunden. Die Steuergates der b Speichertransistoren jeder Gruppe sind dagegen an einer gemeinsamen Programmierleitung angeschlossen und über die Source-Drain-Strecke eines Gruppenwahltransistors blockweise mit einer gemeinsamen Blockleitung verbunden. Das Gate des Gruppenwahltransistors liegt an der entsprechenden Zeilenwahlleitung. Somit wird eine blockweise Anwahl der Gruppen jedes Blockes möglich. Natürlich ist m/b = w eine ganze Zahl.

Bei der bekannten elektrisch löschbaren Speichermatrix sind ferner die Speicherzellen spaltenweise mit je einer durchlaufenden ersten und zweiten Bitleitung kontaktiert und die Blockleitung mit einer Blocksignalquelle über die Source-Drain-Strecke eines Blockwahltransistors, dessen Gate an einem von w Ausgängen eines Blockdekoders angeschlossen ist, je Block verbunden. Die Ausgänge des Blockdekoders sind ausserdem mit den Gates von b Spaltenwahltransistoren verbunden, deren Source-Drain-Strecken wiederum jeweil eine der zweiten Bitleitungen jedes Blocks mit einer der Datenleitung verbunden.

Zur Realisierung der Funktionen «Lesen», «Löschen» und «Schreiben» können bei der bekannten elektrisch löschbaren Speichermatrix die Zeilenwahlleitungen, die Blockleitungen und die Bitleitungen mit Hilfe von entsprechenden Dekodern auf geeignete Potentiale gelegt werden, wobei noch die Adresse des Speichers, der Speichergruppe und des Blockes wählbar sein müssen, d.h. die erwähnten Funktionen sind um den Faktor 2 entsprechend dem Adressenmerkmal «angewählt» und «nicht angewählt» zu erweitern.

Bei der Speichermatrix nach der Erfindung soll ausser den sich damit ergebenden sechs Funktionen eine siebte Funktion «inaktiv» vorgesehen werden, während der keine der genannten sechs Funktionen realisiert wird.

Die Erfindung betrifft somit eine elektrisch löschbare Speichermatix entsprechend dem Oberbegriff des Anspruchs 1.

Es wurde festgestellt, dass bei einer solchen Speichermatrix beim Umprogrammieren von angewählten Speicherzellen oder Gruppen Störungen möglich sind, welche sich auf den Informationsgehalt nicht angewählter Gruppen auswirken.

Da diese Störungen, insbesondere beim Löschen, sich auf angewählte Speicherzellen bzw. Speicherzellengruppen derselben Bitleitung auswirken, ist die Aufgabe der Erfindung, mit geringem Schaltungsaufwand solche Störungen nichtbeteiligter Gruppen beim Umprogrammieren einer elektrisch löschbaren Speichermatrix, an deren Bitleitungen, Zeilenwahlleitungen und Blockleitungen Potentiale entsprechend einer siebten Funktion «inaktiv» anlegbar sind, zuverlässiger zu vermeiden, als es bei der Speichermatrix nach der US-PS Nr. 4266283 der Fall ist. Bei dieser Speichermatrix werden nämlich beim «Löschen» die Datenleitungen an Masse gelegt, die erst über die Schaltstrecken von Spaltentransistoren die zweiten Bitleitungen mit Massepotential verbinden.

Diese Aufgabe wird erfindungsgemäss durch die im kennzeichnenden Teil des Anspruchs 1 angegebenen Massnahmen gelöst.

Dabei wird in den ersten Bitleitungen nach Masse je ein Klemmgatter verwendet, welches aus einer Source-Drain-Parallelschaltung eines Transistors des Anreicherungstyps mit einem Transistor des Verarmungstyps besteht. Dadurch ist die Möglichkeit gegeben, entsprechend einem Signal einer X-Klemmsignalquelle Kx die ersten Bitleitungen wahlweise niederohmig oder hochohmig an Masse zu legen. Beim Schreiben liegt der Ausgang der X-Klemmsignalquelle auf einem ersten Potential V1, welches gleich oder annähernd dem Massenpotential Vo ist. Damit ist gewährleistet, dass beim Schreiben die ersten Bitleitungen hochohmig mit Masse verbunden sind, so dass überhöhte Ströme am Ende des Schreibvorganges und eine dadurch hervorgerufene Begrenzung des Einsatzspannungshubes auf einfache Weise vermieden sind. Aus «Patents Abstracts of Japan» Bd. 5, Nr. 1 (S. 43) (673) ist zwar zur Vermeidung von überhöhten Strömen während eines Schreibvorganges eine Schaltung offenbart, deren zwischen die ersten Bitleitungen der Speichermatrix und Masse liegender Klemmtransistor derart angesteuert wird, dass dieser während eines Lesezyklus einen niedrigen Widerstandswert und während eines Schreibzyklus einen mittleren Widerstandswert annimmt. Bei den Speicherzellen dieser Speichermatrix handelt es sich aber um einen Typ, in den unter Verwendung eines Avalanche-Durchbruches geschrieben wird, wobei eine punch-through übermässige Ströme zur Folge haben kann. Solche übermässigen Ströme werden mittels eines Transistors vermieden, der in Sättigung geschaltet ist und daher zur Begrenzung und somit zur Verhütung von übermässigen Strömen beim punchthrough dient.

Die Erfindung wird im folgenden anhand der Zeichnung erläutert, deren

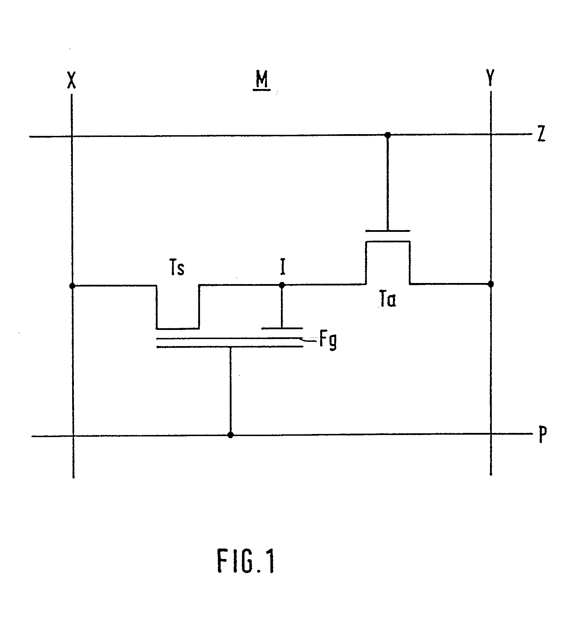

Fig. 1 schematisch die in der Speichermatrix nach der Erfindung verwendete Speicherzelle veranschaulicht und deren

Fig. 2 das Prinzipschaltbild der elektrisch löschbaren Speichermatrix nach der Erfindung zeigt.

In der Speichermatrix nach der Erfindung kann beispielsweise eine Speicherzelle verwendet werden, wie sie in der Zeitschrift «Electronics» vom 28. Februar 1980, Seiten 113 bis 117 beschrieben wird. Diese weist einen Speichertransistor Ts mit einer potentialmässig schwebenden Elektrode Fg auf, an der mittels eines Tunneloxidbereichs in einer Dicke von weniger als 200 Å ein Injektor I an der Drainzone des Speichertransistors Ts realisiert wird. Durch den Tunneloxidbereich können in beiden Richtungen Elektronen in die oder aus der potentialmässig schwebenden Gatteelektrode Fg injiziert werden. Die Richtung der Ladungsträgerinjektion ist lediglich von den Potentialen des Steuergates des Speichertransistors Ts und der Drainelektrode abhängig. Ein Fowler-Nordheim-Tunneln von Elektronen kann bei Oxiddicken von 200 Å bereits mit Potentialen kleiner als 20 V erreicht werden.

In der zur Verwendung kommenden Speicherzelle ist ferner noch ein Auswahltransistor Ta vorgesehen, dessen Gate mit einer Zeilenwahlleitung Z verbunden ist. Das Steuergate des Speichertransistors liegt dagegen an einer Programmierleitung P. Die Source-Drain-Strecke des Speichertransistors Ts liegt einerseits zwischen dem Injektor I und einer ersten Bitleitung X, während andererseits der Injektor über die Source-Drain-Strecke des Auswahltransistors Ta mit einer zweiten Bitleitung Y verbunden ist.

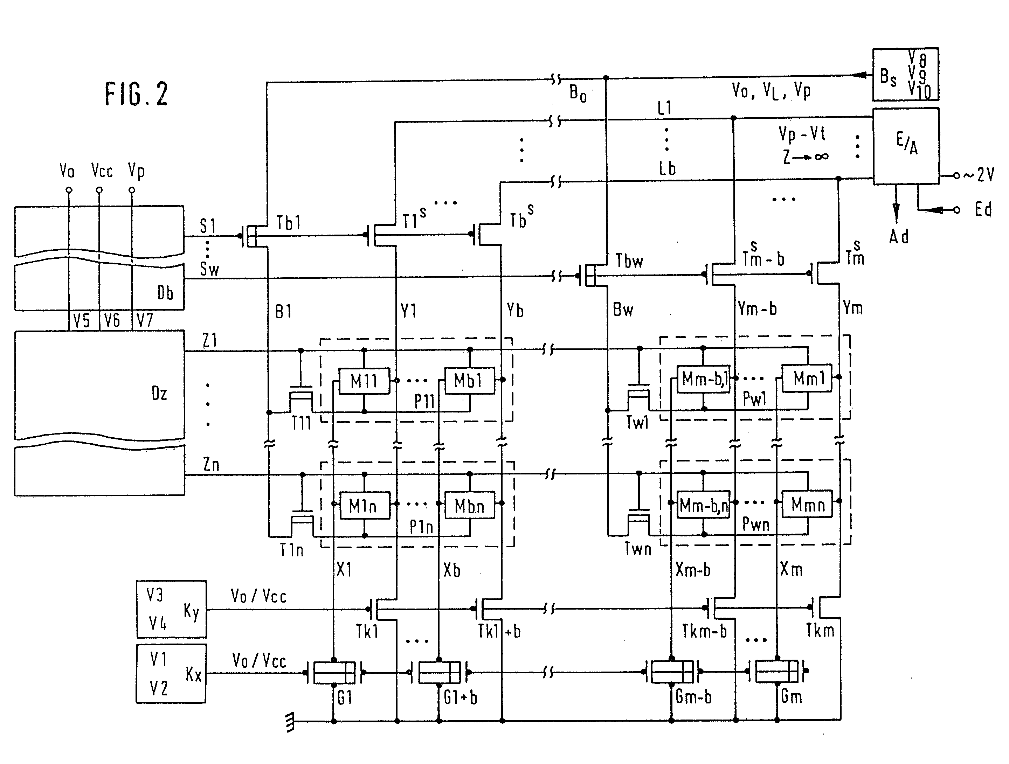

Die Fig. 2 veranschaulicht die matrizenartige Anordnung der Speicherzellen M11 bis Mmn sowie die Verschaltung mit der in Form von Blöcken angegebenen Peripherieschaltung, welche aus einem Zeilendekoder Dz, einer Blocksignalquelle Bs, einem Blockdekoder Db, einer X-Klemmsignalquelle Kx, einer Y-Klemmsignalquelle Ky und einer Datenschaltung E/A besteht. Die Speicherzellen sind zu Gruppen von je b Speicherzellen an je einer gemeinsamen Programmierleitung P11 ... Pwn zusammengefasst, an der die Steuergates der Speichertransistoren liegen. Die Gruppen wiederum sind in Blöcken mit je einer gemeinsamen Blockleitung B1 ... Bw angeordnet, welche über die Source-Drain-Strecke eines Gruppenwahltransistors T11 ... Twn mit je einer Programmierleitung P11 ... Pwn verbunden ist. Die Gruppenwahltransistoren werden vorzugsweise wie die Blockwahltransistoren Tb1 ... Tbw als Isolierschichtfeldeffekttransistoren des Verarmungstyps ausgebildet. Letztere Transistoren verbinden blockweise die Blockleitungen B1 ... Bw mit der Blocksignalquelle Bs. Das Anwählen einer der Zeilen erfolgt mit Hilfe des Zeilendekoders Dz über die betroffene der Zeilenwahlleitungen Z1 ... Zn, welche sowohl mit den Gates der Gruppenwahltransistoren T11 ... Twn als auch mit den Gateelektroden der Auswahltransistoren Ta der zugehörigen Zeile verbunden ist.

Das Anwählen der Blöcke erfolgt dagegen mit Hilfe des Blockdekoders Db, dessen Ausgänge S1 ... Sw sowohl mit den Gates der zugeordneten Blockwahltransistoren Tb1 ... Tbw als auch blockweise mit den Gates von b Spaltenwahltransistoren $T1^s$ ... $Tm^s$ verbunden sind. Über die Source-Drain-Strecken der letztgenannten Spaltenwahltransistoren können wahlweise die zweiten Bitleitungen Y1 ... Ym eines Blockes an die Datenleitungen L1 ... Lb der Datenschaltung E/A angelegt werden, über die die Daten eingegeben und ausgelesen werden. Entsprechend der angewählten Gruppenadresse und der Funktion «Schreiben» oder «Lesen» steht auf den Datenleitungen das zum Schreiben verwendete Potential Vp-Vt (Vt = Schwellspannung) zur Verfügung. Im Falle des «Lesens» sind die Datenleitungen mit einem Leseverstärker verbunden, der eine Konstantspannung von ca. 2 V liefert, wie in der Fig. 2 angegeben. Die Datenschaltung E/A weist ferner den Dateneingang Ed und den Datenausgang Ad auf.

Entsprechend der Erfindung liegt zwischen jeder der m ersten Bitleitungen X1 ... Xm und Masse die Schaltstrecke eins von m Klemmgattern G1 ... Gm. Jedes Klemmgatter enthält die Source-Drain-Parallelschaltung eines Feldeffekttransistors des Anreicherungstyps mit einem Feldeffekttransistor des Verarmungstyps. Ein solches Klemmgatter schafft die Möglichkeit, die einzelnen ersten Bitleitungen X1 ... Xm wahlweise hochohmig oder niederohmig an Masse zu legen. Die dazu erforderlichen Potentiale für V1 gleich oder annähernd dem Massepotential Vo, oder für V2 gleich oder annähernd dem Betriebspotential Vcc, liefert die X-Klemmsignalquelle Kx.

Da für den Fall des Löschens die zweiten Bitleitungen Y1 ... Ym an Masse gelegt werden müssen, liegt an jeder der zweiten Bitleitungen Y1 ... Ym einer der Klemmtransistoren Tk1 ... Tkm, dessen Gate von einer Y-Klemmsignalquelle Ky entsprechend V3 ≃ Vo oder V4 ≃ Vcc angesteuert wird.

Die von den Peripherieschaltungsblöcken der Speichermatrix nach der Erfindung entsprechend der gewählten Funktionsweise zur Verfügung gestellten Potentiale ergeben sich aus folgender Tabelle:

*(Tabelle auf der nächsten Seite)*

Darin bedeuten die unter M(1) angegebenen Potentiale Werte, wie sie an den in Spalte 1 angegebenen Schaltungselementen bzw. Leitungen auftreten, für den Fall einer angewählten Zelle und die unter M(O) angegebenen Werte die der nichtangewählten Zelle. Beim Schreiben liegt also sowohl an der Zeilenwahlleitung Z als auch an der Blockwahlleitung S der betreffenden Zelle das Potential V7 = Vp der Programmierspannungsquelle und an der betroffenen Datenleitung das Potential Vp-Vt. An der zugehörigen Blockleitung B tritt das Potential Vo auf. Sowohl die X-Klemmsignalquelle Kx als auch die Y-Klemmsignalquelle Ky liefern ein Potential in der Nähe des Massepotentials, so

| | Lesen M(1) | Lesen M(0) | Löschen M(1) | Löschen M(0) | Schreiben M(1) | Schreiben M(0) | Inaktiv |
|---|---|---|---|---|---|---|---|
| Z1 ... Zn | ~Vcc | ~Vo | ~Vp | ~Vo | ~Vp | ~Vo | ~Vcc |
| S1 ... Sw | ~Vcc | ~Vo | ~Vp | ~Vo | ~Vp | ~Vo | ~Vcc |
| L1 ... Lb | Leseverstärker von E/A | | hochohmig | | ~Vp-Vt | hochohmig | hochohmig |
| Bo | ~$V_L$ | | ~Vp | | ~Vo | | ~Vo |
| Kx | ~Vcc | | ~Vcc | | ~Vo | | ~Vcc |
| Ky | ~Vo | | ~Vcc | | ~Vo | | ~Vcc |

dass der zugehörige Klemmtransistor gesperrt und das betroffene Klemmgatter einen Source-Drain-Widerstand entsprechend dem hochohmigen Widerstand des Feldeffekttransistors vom Verarmungstyp aufweist.

Der Blockdekoder Db enthält w NOR-Dekoderschaltungsteile, deren Ausgänge mit den einzelnen Blockwahlleitungen S1 ... Sw verbunden sind. An diesem können, wie in der Fig. 2 angedeutet, entsprechend den Funktionen der vorstehenden Tabelle die Potentiale V5 gleich oder annähernd dem Massepotential Vo, das Potential V6 gleich oder annähernd dem Betriebspotential Vcc oder das Potential V7 entsprechend dem Potential Vp der Programmierspannungsquelle auftreten, und gleiches gilt für den Zeilendekoder Dz. Die Blocksignalquelle Bs stellt an ihrem Ausgang Bo wahlweise eins von drei Potentialen, V8 gleich oder annähernd dem Massepotential Vo, V9 gleich der Lesespannung $V_L$ oder V10 gleich dem Potential Vp der Programmierspannungsquelle, zur Verfügung.

Um eine möglichst lange Datenhaltungszeit zu gewährleisten, sollten während der Auslesevorgänge und während Betriebspausen die Potentiale an den Anschlüssen der Speicherzellen möglichst nahe Vo gehalten werden. In Weiterbildung der Speichermatrix in der Erfindung kann eine Lesespannung $V_L$ gleich dem Massepotential Vo gewählt werden, wenn die Speichertransistoren Ts an der Substratoberfläche unter dem Steuergate eine solche Konzentration an Dotierungen des Leitungstyps der Source- bzw. Drain-Zonen aufweisen, dass vor der ersten Programmierung der Zellen bei einer solchen Zelle mit auf Massepotential gelegten Programmierleitungen und ersten Bitleitungen bei Anlegen eines Potentials gegen Masse an die zweiten Bitleitungen jeweils ein Strom durch die Source-Drain-Strecke der einzelnen Zellen fliesst.

Die weitgehende Störsicherheit einer Speichermatrix nach der Erfindung gemäss der Fig. 2 ergibt sich daraus, dass während der Umprogrammiervorgänge das Potential auf den Programmierleitungen P nicht angewählter Gruppen ein Potential von höchstens dem Betrag der Einsatzspannung eines Gruppenwahltransistors T11 ... Twn von etwa 3 V und auf der ersten Bitleitung X ein Potential von höchstens der Einsatzspannung eines «geschriebenen», also auf die logische Null gesetzten Speichertransistors von etwa 7 V auftreten kann. Es ist ferner gewährleistet, dass an den Zeilenwahlleitungen Z1 ... Zn ein Umprogrammierpotential in Höhe der Versorgungsspannung Vp und an den zweiten Bitleitungen Y1 ... Ym ein Umprogrammierpotential in Höhe der Versorgungsspannung Vp, reduziert um eine Einsatzspannung von etwa 3 V des betroffenen Feldeffekttransistors vom Verarmungstyp, bei geringster Stromaufnahme aus der Versorgungsquelle, auftritt.

## Patentansprüche

1. Elektrisch löschbare Speichermatrix (EEPROM), die in w Blöcken zu je b Spalten und in n Zeilen angeordneten Speichergruppen mit je b elektrisch umprogrammierbaren Speicherzellen (M) aufweist, wobei jede der Speicherzellen je einen in beiden Richtungen zu je einer elektrisch schwebenden Elektrode (Fg) wirksamen Tunnelinjektor (I) enthält, der einerseits über die Source-Drain-Strecke eines Speichertransistors (Ts) mit einer ersten Bitleitung (X) und andererseits über die Source-Drain-Strecke eines Auswahltransistors (Ta) mit einer zweiten Bitleitung (Y) verbunden ist, wobei das Steuergate des Speichertransistors an einer Programmierleitung (P) angeschlossen ist, während das Gate des Auswahltransistors (Ta) mit einer Zeilenwahlleitung (Z) kontaktiert ist, bei welcher Speichermatrix

– die Gates der w · b = m Auswahltransistoren (Ta) jeder Zeile über eine gemeinsame Zeilenwahlleitung (Z1 ... Zn) mit je einem von n Ausgängen eines Zeilendekoders (Dz) verbunden sind,

– die Steuergates der b Speichertransistoren (Ts) jeder Gruppe an einer gemeinsamen Programmierleitung (P11 ... Pwn) angeschlossen sind und über die Source-Drain-Strecke eines Gruppenwahltransistors (T11 ... Twn), dessen Gate an der entsprechenden gemeinsamen Zeilenwahlleitung (Z1 ... Zn) liegt, blockweise mit einer gemeinsamen Blockleitung (B1 ... Bw) verbunden sind, wobei m/b = w eine ganze Zahl ist,

– die Speicherzellen spaltenweise mit je einer durchlaufenden gemeinsamen ersten und zweiten Bitleitung (X1 ... Xm; Y1 ... Ym) kontaktiert sind,

— die Blockleitungen (B1 ... Bw) mit einer Blocksignalquelle (Bs) über die Source-Drain-Strecke eines Blockwahltransistors (Tb1 ... Tbw) je Block verbunden sind, dessen Gates an einem von w Ausgängen (S1 ... Sw) eines Blockdekoders (Db) angeschlossen ist,

— die Ausgänge (S1 ... Sw) des Blockdekoders (Db) jeweils blockweise mit den Gates von b Spaltenwahltransistoren (T1ˢ ... Tbˢ; Tm-bˢ ... Tmˢ) verbunden sind, deren Source-Drain-Strecken wiederum jeweils eine der zweiten Bitleitungen (Y1 ... Yb; ... ; Ym-b ... Ym) jedes Blockes mit einer der Datenleitungen (L1 ... Lb) verbinden, und

— die Zeilenwahlleitungen (Z1 ... Zn), die Blockleitungen (B1 ... Bw), die ersten Bitleitungen (X1 ... Xm) und die zweiten Bitleitungen (Y1 ... Ym) entsprechend einer ersten Funktion «Lesen angewählt», einer zweiten Funktion «Lesen nicht angewählt», einer dritten Funktion «Löschen angewählt», einer vierten Funktion «Löschen nicht angewählt», einer fünften Funktion «Schreiben angewählt», und einer sechsten Funktion «Schreiben nicht angewählt» an geeignete Potentiale legbar sind,

dadurch gekennzeichnet,

— dass zwischen den m ersten Bitleitungen (X1 ... Xm) und Masse die Schaltstrecken je eines von m Klemmgattern (G1 ... Gm) liegen, wobei ein Klemmgatter aus einer Source-Drain-Parallelschaltung eines Transistors des Anreicherungstyps und eines Transistors des Verarmungstyps besteht,

— dass die Gates aller Klemmgatter (G1 ... Gm) gemeinsam von einer X-Klemmsignalquelle (Kx) derart steuerbar sind, dass wahlweise ein erstes Potential (V1) gleich oder annähernd dem Massepotential (Vo) entsprechend der fünften Funktion oder der sechsten Funktion, oder ein zweites Potential (V2) gleich oder annähernd dem Betriebspotential (Vcc) entsprechend der ersten bis vierten oder einer siebten Funktion «inaktiv» an den Gates anliegt,

— dass zwischen den zweiten Bitleitungen (Y1 ... Ym) und Masse jeweils eine Source-Drain-Strecke eines von m Klemmtransistoren (Tk1 ... Tkm) liegt und,

— dass die Gates aller Klemmtransistoren (Tk1 ... Tkm) von einer Y-Klemmsignalquelle (Ky) entweder entsprechend der ersten, zweiten, fünften oder sechsten Funktion auf ein drittes Potential (V3) gleich oder annähernd gleich dem Massepotential (Vo) oder entsprechend der dritten, vierten, oder siebten Funktion auf ein viertes Potential (V4) gleich oder annähernd dem Betriebspotential (Vcc) legbar sind.

2. Elektrisch löschbare Speichermatrix nach Anspruch 1, dadurch gekennzeichnet, dass die Speichertransistoren (Ts) an der Substratoberfläche unter den Steuergates eine solche Konzentration von Dotierungen des Leitungstyps der Source-Drain-Zonen aufweisen, dass vor der ersten Programmierung der Speichertransistoren bei auf Massepotential gelegten Programmierleitungen (P11 ... Pwn) und ersten Bitleitungen (X1 ... Xm) und bei Anlegen eines Potentials gegen Masse an die zweiten Bitleitungen (Y1 ... Ym) Ströme durch die Speichertransistoren fliessen.

3. Elektrisch löschbare Speichermatrix nach Anspruch 2, dadurch gekennzeichnet, dass von der Blocksignalquelle (Bs) entsprechend der ersten oder zweiten Funktion («Lesen») ein Potential nahe oder gleich dem Massepotential (Vo), entsprechend der dritten und vierten Funktion («Löschen») das Potential (Vp) der Programmierspannungsquelle oder entsprechend der fünften, sechsten und der siebten Funktion das Massepotential (Vo) anlegbar ist.

4. Elektrisch löschbare Speichermatrix nach Anspruch 2 oder 3, dadurch gekennzeichnet, dass die einzelnen Blockwahlleitungen (S1 ... Sw), welche mit den Gateelektroden von Blockwahltransistoren (Tb1 ... Tbw) des Verarmungstyps und den Gateelektroden von Spaltenwahltransistoren (T1ˢ ... Tmˢ) des Anreicherungstyps verbunden sind, von je einer NOR-Dekoderschaltung des Blockdekoders (Db) ansteuerbar sind und die einzelnen Zeilenwahlleitungen (Z1 ... Zm), welche mit den Gateelektroden der Gruppenwahltransistoren (T11 ... Twn) und denen der Auswahltransistoren (Ta) verbunden sind, von je einer NOR-Dekoderschaltung des Zeilendekoders (Dz) ansteuerbar sind, und zwar

— entsprechend der zweiten, vierten oder sechsten Funktion mit einem fünften Potential (V5) gleich oder annähernd dem Massepotential (Vo),

— entsprechend der ersten oder siebten Funktion mit einem sechsten Potential (V6) gleich oder annähernd dem Betriebspotential (Vcc) oder

— entsprechend der dritten oder fünften Funktion mit einem siebten Potential (V7) gleich oder annähernd der Programmierspannung (Vp).

## Claims

1. Electrically erasable memory matrix (EEPROM) comprising storage groups arranged in w blocks with b columns each and arranged in n rows, each with b electrically re-programmable storage cells (M), with each of the storage cells containing respectively one tunnel injector (1) which is effective in both directions and toward respectively one electrically floating gate electrode (Fg) which, on the one hand, via the source-drain line of a memory transistor (Ts) is connected to a first bit line (X) and, on the other hand, via the source-drain line of a selection transistor (Ta), is connected to a second bit line (Y), with the control gate of the memory transistor being connected to a programming line (P) while the gate of the selection transistor (Ta) is in contact with a row selection line (Z), in which memory matrix

— the gates of the w · b = m selection transistor (Ta) of each row, via one common row selection line (Z1 ... Zn) are connected to respectively one of n outputs of a row decoder (Dz),

— the control gates of the b memory transistors (Ts) of each group are connected to one common programming line (P11 ... Pwn) and, via the source-drain line of a group selection transistor (T11 ... Twn) whose gate is connected to the corresponding common row selection line (Z1 ... Zn), are connected blockwisely to one common block line (P1 ... Pw), with m/b = w being a whole number,

— the storage cells are columnwisely in contact with respectively one continuous, common first and second bit line (X1 ... Xm; Y1 ... Ym),

— the block lines (B1 ... Bw) are connected to a block signal source (Bs) via the source-drain line of one block selection transistor (Tb1 ... Tbw) per block, with the gates thereof being connected to one of w outputs (S1 ... Sw) of the block decoder (Db),

— the outputs (S1 ... Sw) of said block decoder (Db) are each connected in blocks to the gates of b column selection transistors (T1$^s$ ... Tb$^s$; Tm-b$^s$ ... Tm$^s$) whose source-drain lines, in turn, respectively connect one of the second bit lines (Y1 ... Yb; ...; Ym-b ... Ym) of each block to one of the data lines (L1 ... Lb), and

— the row selection line (Z1 ... Zn), the block lines (B1 ... Bw), the first bit lines (X1 ... Xm) and the second bit lines (Y1 ... Ym) are capable of being connected to suitable potentials in accordance with a first function «Reading Selected», a second function «Reading Not Selected», a third function «Erasing Selected», a fourth function «Erasing Not Selected», a fifth function «Writing Selected», and a sixth function «Writing Not Selected», characterized in

— that between said m first bit lines (X1 ... Xm) and ground, there are disposed the switching sections of respectively one of m clamping gates (G1 ... Gm), with one clamping gate consisting of a source-drain parallel arrangement of one transistor of the enhancement type and of one transistor of the depletion type, and

— that the gates of all of said clamping gates (G1 ... Gm) are jointly controlled by one X-clamping signal source (Kx) in such a way that optionally either a first potential (V1) identical or almost identical to the ground potential (Vo) according to the fifth function or the sixth function, or else a second potential (V2) identical or almost identical to the operating potential (Vcc) corresponding to the first through fourth or a seventh function «Inactive» is applied to the gates,

— that between said second bit lines (Y1 ... Ym) and ground there is respectively disposed one source-drain line of one of m clamping transistors (Tk1 ... Tkm), and

— that the gates of all of said clamping transistors (Tk1 ... Tkm), by a Y-clamping signal source (Ky), are capable of being connected either in accordance with the first, second, fifth or sixth function, to a third potential (V3) which is identical or almost identical to the ground potential (Vo) or else in accordance with the third, fourth, or seventh function, to a fourth potential (V4) which is identical or almost identical to the operating potential (Vcc).

2. An electrically erasable memory matrix as claimed in Claim 1, characterized in that said memory transistors (Ts), on the substrate surface below the control gates, show to have such a concentration of dopants of the conductivity type of the source-drain regions, that prior to the first programming of said memory transistors, in the case of programming lines (P11 ... Pwn) and first bit lines (X1 ... Xm) connected to ground potential, and when applying a potential against ground to said second lines (Y1 ... Ym), currents will flow through said memory transistors.

3. An electrically erasable memory matrix as claimed in Claim 2, characterized in that by said block signal source (Bs), in accordance with the first or the second function («Reading»), a potential close to or equalling the ground potential (Vo) is capable of being applied, and in accordance with the third and fourth function («Erasing»), the potential (Vp) of the programming voltage source or, in accordance with the fifth, sixth or seventh function, the ground potential (Vo) is capable of being applied.

4. An electrically erasable memory matrix as claimed in Claim 2 or 3, characterized in that said individual block selection lines (S1 ... Sw) which are connected to the gate electrodes of block selection transistors (Tb1 ... Tbw) of the depletion type, and to the gate electrodes of column selection transistors (T1$^s$ ... Tm$^s$) of the enhancement type, are capable of being controlled by respectively one NOR decoder circuit of said block decoder (Db), and that the individual row selection lines (Z1 ... Zm) which are connected to the gate electrodes of said group selection transistors (T11 ... Twn) and to those of said selection transistors (Ta), are capable of being controlled by respectively one NOR decoder circuit of said row decoder (Dz), i.e.,

— in accordance with the second, fourth or sixth function, by a fifth potential (V5) identical or almost identical to the ground potential (Vo),

— in accordance with the first or seventh function, by a sixth potential (V6) identical or almost identical to the operating potential (Vcc), or

— in accordance with the third or fifth function, by a seventh potential (V7) identical or almost identical to the programming voltage (Vp).

## Revendications

1. Matrice de mémoire effaçable électriquement (EEPROM), comportant des groupes de mémoire qui ont chacun b cellules de mémoire (M) reprogrammables électriquement et qui sont agencées dans w blocs, à chaque fois en b colonnes et n rangées, chacune des cellules de mémoire contenant un injecteur tunnel (I) agissant dans les deux directions sur une électrode à grille électriquement flottante (Fg), cet injecteur étant relié, d'une part, via le trajet source-drain d'un transistor mémoire (Ts), à un premier conducteur de bit (X) et, d'autre part, via le trajet source-drain d'un transistor de sélection (Ta), à un deuxième conducteur de bit (Y), la grille de commande du transistor mémoire étant raccordée à un conducteur de programmation (P), tandis que la grille du transistor de sélection (Ta) est connectée à un conducteur de sélection de rangée (Z), matrice dans laquelle

— les grilles des w · b = m transistors de sélection (Ta) de chaque rangée sont reliées, par un conducteur de sélection de rangée commun (Z1 ... Zn), chacune à l'une des n sorties d'un décodeur de rangée (Dz),

— les grilles de commande des b transistors mémoire (Ts) de chaque groupe sont raccordées à un conducteur de programmation commun (P11 ... Pwn) et, par l'intermédiaire du trajet source-drain d'un transistor de sélection de groupe (T11 ... Twn) dont la grille est en liaison avec le conducteur de sélection de rangée commun correspondant (Z1 ... Zn), sont reliées par bloc à un conducteur commun (B1 ... Bw) de bloc, m/b = w étant un nombre entier,

— les cellules de mémoire sont connectées, colonne par colonne, à chaque fois à un premier et à un deuxième conducteur de bit commun (X1 ... Xm; Y1 ... Ym) traversant la matrice,

— les conducteurs de bloc (B1 ... Bw) sont reliés à une source de signal de bloc (Bs) par le trajet source-drain d'un transistor de sélection de bloc (Tb1 ... Tbw) pour chaque bloc, la grille de ce transistor étant raccordée à l'une de w sorties (S1 ... Sw) d'un décodeur de bloc (Db),

— les sorties (S1 ... Sw) du décodeur de bloc (Db) sont reliées, bloc par bloc, aux grilles de b transistors de sélection de colonne (T1ˢ ... Tbˢ; Tm-bˢ ... Tmˢ) dont les trajets source-drain relient à leur tour l'un des deux conducteurs de bit (Y1 ... Yb; ... ; Ym-b ... Ym) de chaque bloc à l'un des conducteurs de donnée (L1 ... Lb), et

— les conducteurs de sélection de rangée (Z1 ... Zn), les conducteurs de bloc (B1 ... Bw), les premiers conducteurs de bit (X1 ... Xm) et les deuxièmes conducteurs de bit (Y1 ... Ym) peuvent être mis à des potentiels appropriés corrélatifs à une première fonction «lecture sélectionnée», à une deuxième fonction «lecture non sélectionnée», à une troisième fonction «effacement sélectionné», à une quatrième fonction «effacement non sélectionné», à une cinquième fonction «écriture sélectionnée», et à une sixième fonction «écriture non sélectionnée», caractérisée

— en ce qu'entre les m premiers conducteurs de bit (X1 ... Xm) et la masse sont disposés des trajets commandés, à chaque fois celui de l'une de m portes de blocage (G1 ... Gm), chaque porte de blocage étant constituée du branchement parallèle des trajets source-drain d'un transistor du type à enrichissement et d'un transistor du type à appauvrissement,

— en ce que les grilles de toutes les portes de blocage (G1 ... Gm) peuvent être commandées en commun par une source (Kx) de signal de blocage X de façon telle qu'il y ait sélectivement, en mode inactif, sur la grille, un premier potentiel (V1) égal ou approximativement égal au potentiel de masse (Vo), corrélatif à la cinquième ou à la sixième fonction, ou un deuxième potentiel (V2) égal ou approximativement égal au potentiel de fonctionnement (Vcc), corrélatif à la première et à la quatrième fonction ou à une septième fonction,

— en ce qu'entre les deuxièmes conducteurs de bit (Y1 ... Ym) et la masse il y a à chaque fois un trajet source-drain de l'un de m transistors de blocage (Tk1 ... Tkm), et

— en ce que les grilles de tous les transistors de blocage (Tk1 ... Tkm), par une source (Ky) de signal de blocage Y, corrélativement à la première, la deuxième, la cinquième ou la sixième fonction, peuvent être mises à un troisième potentiel (V3) égal ou approximativement égal au potentiel de masse (Vo), ou mises, corrélativement à la troisième, la quatrième ou la septième fonction, à un quatrième potentiel (V4) égal ou approximativement égal au potentiel de fonctionnement (Vcc).

2. Matrice de mémoire effaçable électriquement selon la revendication 1, caractérisée en ce que les transistors mémoire (Ts) présentent, à la surface du substrat en dessous de la grille de commande, une concentration en dopants du type de conductibilité des zones source-drain telle qu'avant la première programmation des transistors mémoire des courants passent par ces transistors mémoire, les conducteurs de programmation (P11 ... Pwn) et les premiers conducteurs de bit (X1 ... Xm) étant mis au potentiel de masse, et un potentiel par rapport à la masse étant appliqué aux deuxièmes conducteurs de bit (Y1 ... Ym).

3. Matrice de mémoire effaçable électriquement selon la revendication 2, caractérisée en ce que la source (Bs) de signal de bloc peut appliquer, corrélativement à la première ou la deuxième fonction («lecture»), un potentiel proche du potentiel de masse (Vo) ou voisin de celui-ci, corrélativement à la troisième et à la quatrième fonction («effacement») le potenttiel (Vp) de la source de tension de programmation, ou, corrélativement à la cinquième, à la sixième et à la septième fonction, le potentiel de masse (Vo).

4. Matrice de mémoire effaçable électriquement selon la revendication 2 ou 3, caractérisée en ce que les conducteurs de sélection de bloc individuels (S1 ... Sw) qui sont reliés aux électrodes de grille de transistors de sélection de bloc (Tb1 ... Tbw) du type à appauvrissement et aux électrodes de grille de transistors de sélection de colonne (T1ˢ ... Tmˢ) du type à enrichissement sont attaqués chacun par un circuit décodeur OU-NON du décodeur de bloc (Db), et les conducteurs de sélection de rangée individuels (Z1 ... Zm), qui sont reliés aux électrodes de grille des transistors de sélection de groupe (T11 ... Twn) et auxquels les transistors de sélection (Ta) sont reliés, sont commandés chacun par un circuit décodeur OU-NON du décodeur de ligne Dz, et cela:

— corrélativement à la deuxième, à la quatrième ou à la sixième fonction, par un cinquième potentiel (V5) égal ou approximativement égal au potentiel de masse (Vo),

— corrélativement à la première ou à la septième fonction, par un sixième potentiel (V6) égal ou approximativement égal au potentiel de fonctionnement (Vcc), ou

— corrélativement à la troisième ou à la cinquième fonction, par un septième potentiel (V7) égal ou approximativement égal à la tension de programmation (Vp).

FIG.1

FIG. 2